# EUROPEAN PATENT SPECIFICATION

(11) **EP 4 592 696 B1**
(45) Date of publication and mention of the grant of the patent: **21.10.2026**
(21) Application number: 24861368.9
(22) Date of filing: 17.06.2024
(51) Int. Cl.: G01R 31/392, G01R 31/367, G01R 31/382, G01R 31/396, G01R 31/36, G01R 31/371, B60L 58/16, B60L 3/00, B60L 3/12, B60L 58/12, B60L 58/21

(54) **METHOD FOR ESTIMATING STATE OF HEALTH (SOH) OF BATTERY AND BATTERY SYSTEM PROVIDING THE SAME**
VERFAHREN ZUR SCHÄTZUNG DES BATTERIEGESUNDHEITSZUSTANDS (SOH) UND BATTERIESYSTEM DAMIT
PROCÉDÉ D'ESTIMATION D'ÉTAT DE SANTÉ (SOH) DE BATTERIE ET SYSTÈME DE BATTERIE FOURNISSANT CELUI-CI

(30) Priority: 11.12.2023 KR 20230178549
(43) Date of publication of application: 30.07.2025
(73) Proprietor: LG Energy Solution, Ltd., Seoul 07335 (KR)
(72) Inventor: WON, Seongyeon, Daejeon 34122 (KR)
(74) Representative: Plasseraud IP
(86) International application number: PCT/KR2024/008322
(87) International publication number: WO 2025/127282

(56) References cited:
- CN-A- 114 325 446
- CN-A- 114 895 191
- CN-A- 116 388 347
- KR-A- 20120 120 889
- KR-A- 20160 004 077
- KR-A- 20230 070 628
- KR-A- 20230 147 795
- US-A1- 2021 278 470

## Description

### [Technical Field]

The present disclosure relates to a method for estimating a state of health (SOH) of a battery and a battery system providing the same.

### [Background Art]

A battery mounted on a high-power product, such as an electric vehicle or a hybrid vehicle, includes a plurality of cells connected in series or in parallel because the battery needs to supply a high voltage to a load. In an eco-friendly vehicle, a performance of a battery is directly related to the performance of the vehicle, so a role of a battery management system (BMS), which efficiently manages the state of the battery, is important.

The BMS estimates a state of charge (SOC) of the battery (or battery cell), a state of health (SOH) of the battery, energy used for charging and discharging the battery based on a battery current flowing through the battery, a plurality of cell voltages of a plurality of battery cells, and a battery temperature, and diagnoses a state of the battery based on an estimation result.

Meanwhile, due to the nonlinearity of the battery cells, an SOH or the like of the battery cannot be directly measured. The document CN 114 895 191 A is known, but fails to overcome the aforementioned issue. Therefore, the BMS includes a plurality of SOH estimation models, and each of the plurality of estimation models estimates an SOH or the like of the battery based on battery data.

### [Disclosure]

### [Technical Problem]

The present disclosure attempts to provide a method for estimating a state of health (SOH) of a battery capable of estimating the SOH of the battery according to a state of the battery that changes in real time and a battery system providing the same.

### [Technical Solution]

The object of the invention is achieved by the subject-matter of the independent claims. Advantageous embodiments are defined in the dependent claims. Further examples are provided for facilitating the understanding of the invention.

### [Advantageous Effects]

There are provided a method for estimating a state of health (SOH) of a battery capable of estimating the SOH of the battery in a highly reliable manner by estimating the SOH of the battery according to a state of the battery that changes in real time and a battery system providing the same.

### [Description of the Drawings]

FIG. 1 is a diagram illustrating a battery system according to an exemplary embodiment.
FIG. 2 is a flowchart illustrating a method for estimating a state of health (SOH) of a battery based a relational expression representing a relationship between a total energy amount of the battery and an SOH of the battery according to an exemplary embodiment.
FIG. 3 is a graph based on a relational expression representing a relationship between a total energy amount of the battery and an SOH of the battery according to an exemplary embodiment.
FIG. 4 is a graph based on a relational expression representing a relationship between a total energy amount of the battery and an SOH of the battery according to an exemplary embodiment.
FIG. 5 is a graph based on a relational expression representing a relationship between a total energy amount of the battery and an SOH of the battery according to an exemplary embodiment.
FIG. 6 is a graph illustrating an SOH that varies in real time according to an exemplary embodiment.

### [Mode for Invention]

The exemplary embodiments described in the present specification and the configurations illustrated in the drawings are preferred examples of the present disclosure, and there may be various modifications that may replace the exemplary embodiments of the present specification and the drawings at the time of filing of the present application.

In describing exemplary embodiments herein, detailed descriptions of relevant known technologies will be omitted if they obscure the gist of the exemplary embodiments disclosed herein. Further, the accompanying drawings are provided only to help easily understand exemplary embodiments disclosed herein, and it should be understood that the technical idea disclosed herein is not limited by the accompanying drawings, and covers all modifications, and substitutions falling within the scope of the present disclosure.

Terms including ordinal numbers such as "first" and "second" may be used to describe various components, but these components are not limited by these terms. These terms are used only for the purpose of distinguishing one component from another component.

It is to be understood that when one component is referred to as being "connected to" or "coupled to" another component, one component may be connected or coupled directly to another component or be connected or coupled to another component with an intervening component therebetween. On the other hand, it is to be understood that when one component is referred to as being "directly connected to" or "directly coupled to" another component, one component may be connected to another component with no intervening component therebetween.

It should be understood that terms "include", "have", and the like used herein specify the presence of features, numbers, steps, operations, components, parts, or combinations thereof stated in the specification, but do not preclude the possibility of the presence or addition of one or more other features, numbers, steps, operations, components, parts, or combinations thereof.

Hereinafter, exemplary embodiments disclosed will be described in detail with reference to the accompanying drawings.

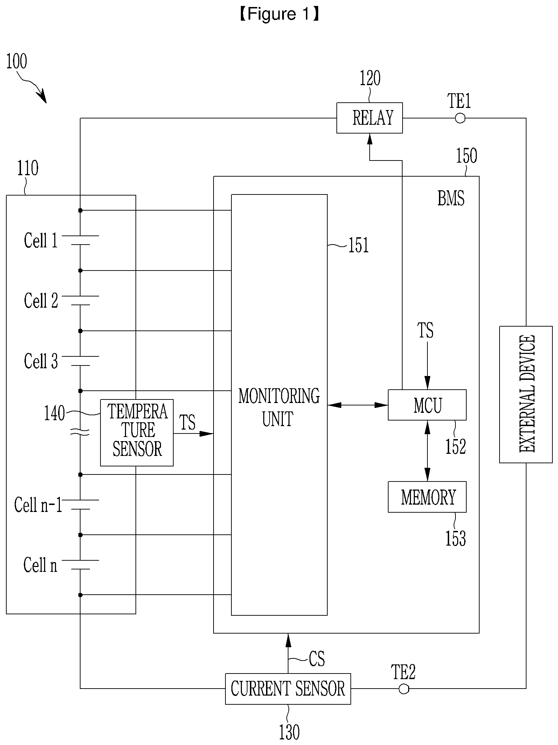

FIG. 1 is a diagram illustrating a battery system according to an exemplary embodiment.

Referring to FIG. 1, a battery system 100 includes a battery 110, a relay 120, a current sensor 130, a temperature sensor 140, and a battery management system (BMS) 150.

Two terminals TE1 and TE2 of the battery system 100 are connected to positive and negative electrodes of the battery 110, the relay 120 is connected between the positive electrode of the battery 110 and the terminal TE1, and the current sensor 130 is connected between the negative electrode of the battery 110 and the terminal TE2. The temperature sensor 140 may be located at a predetermined position within the battery system 100, for example, in an area adjacent to the battery 110, or physically coupled to the battery 110.

The battery 110 may include a plurality of battery cells, and the plurality of battery cells may be connected in series/parallel. Although it is illustrated in FIG. 1 that the battery 110 includes a plurality of battery cells Cell 1 to Cell n connected in series, the components and the connection relationships between the components illustrated in FIG. 1 are merely examples and the disclosure is not limited thereto.

The relay 120 controls an electrical connection between the battery system 100 and an external device. When the relay 120 is turned on, the battery system 100 and the external device are electrically connected to each other to perform charging or discharging, and when the relay 120 is turned off, the battery system 100 and the external device are electrically disconnected from each other. The external device may be a load or a charger.

The current sensor 130 is connected in series to a current path between the battery 110 and the external device. The current sensor 130 may measure a current flowing through the battery 110 and transmit a detection signal (CS) indicating a measurement result to the BMS. The current flowing through the battery 110 may be a charging current for charging the battery 110 or a discharging current supplied from the battery 110 to the external device.

The temperature sensor 140 may detect a temperature of its location and transmit a signal TS indicating the detected temperature to the BMS. The temperature sensor 140 is not limited to that illustrated in FIG. 1, and at least two temperature sensors 140 may be provided to detect temperatures of the plurality of battery cells.

The BMS 150 includes a monitoring unit 151, a main control unit (MCU) 152, and a memory 153.

The monitoring unit 151 is electrically connected to positive and negative electrodes of each of the plurality of battery cells Cell 1 to Cell n to measure a voltage for each of the plurality of battery cells Cell 1 to Cell n.

The monitoring unit 151 transmits information on the measured cell voltage for each of the plurality of battery cells Cell 1 to Cell n to the MCU 152. Specifically, the monitoring unit 151 may measure a cell voltage for each of the plurality of battery cells Cell 1 to Cell n at predetermined cycles during a rest period in which no charging or discharging occurs, and transmit the measured cell voltage to the MCU 152.

The MCU 152 may estimate a state of charge (SOC) for each of the plurality of battery cells using the cell voltage for each of the plurality of battery cells Cell 1 to Cell n received from the monitoring unit 151 during the rest period.

The MCU 152 may obtain a current level of a current flowing through the battery 110 during a charging/discharging period of the battery 110 according to the detection signal CS received from the current sensor 130, and obtain a temperature level of the battery 110 according to the detection signal TS received from the temperature sensor 140.

The memory 153 may store programs and data for controlling and managing the components included in the BMS 150, and store information obtained by the current sensor 130, the temperature sensor 140, and the monitoring unit 151, and information calculated by the MCU 152.

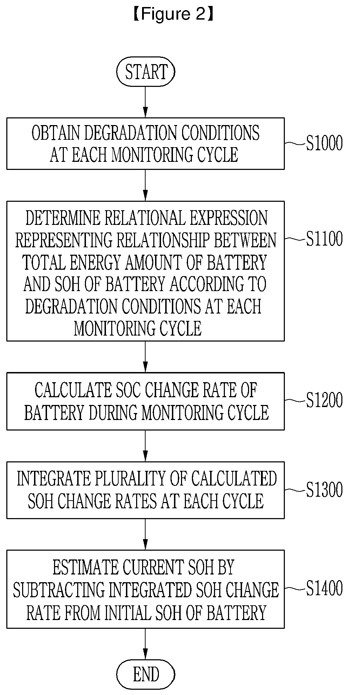

Hereinafter, a method for estimating an SOH of the battery using information stored in the memory 153 by the MCU 152 will be described with reference to FIGS. 2 to 6.

FIG. 2 is a flowchart illustrating a method for estimating an SOH of a battery based a relational expression representing a relationship between a total energy amount of the battery and an SOH of the battery according to an exemplary embodiment.

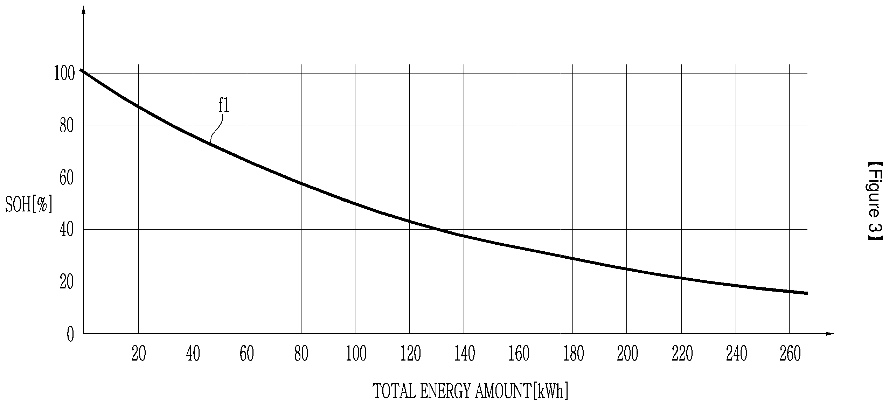

FIGS. 3 to 5 are graphs each based on a relational expression representing a relationship between a total energy amount of the battery and an SOH of the battery according to an exemplary embodiment.

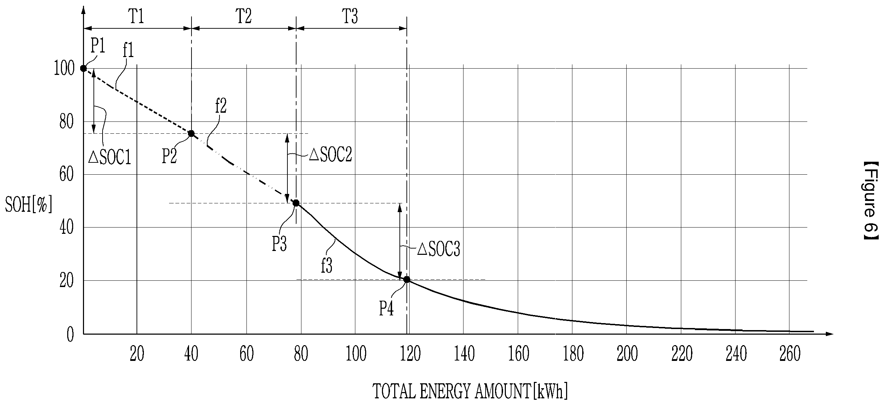

FIG. 6 is a graph illustrating an SOH that varies in real time according to an exemplary embodiment.

Referring to FIG. 2, the BMS may obtain degradation conditions at each predetermined monitoring cycle to estimate an SOH of the battery 110 that varies in real time according to the use of the battery 110 (S1000).

As the battery 110 is used, the SOH of the battery 110 decreases, which is called degradation, and the conditions under which the battery 110 degrades refer to factors involved in the degradation.

Specifically, the degradation conditions may include a temperature of the battery 110, a charge rate of the battery 110, a discharge rate of the battery 110, a highest SOC of the battery 110, and a lowest SOC of the battery 110.

The BMS 150 may obtain a temperature level of the battery 110 according to the detection signal TS received from the temperature sensor 140.

In addition, the BMS 150 may obtain a current level of a current flowing through the battery 110 during the charging/discharging period of the battery 110 according to the detection signal CS received from the current sensor 130, and may measure a charge rate (C-rate) of the battery 110 and a discharge rate (D-rate) of the battery 110 based on the current flowing through the battery 110.

Specifically, the BMS 150 may measure a charge rate of the battery 110 by dividing a current flowing when charging the battery 110 by a current capacity of the battery 110, and may measure a discharge rate of the battery 110 by dividing a current flowing when discharging the battery 110 by a current capacity of the battery 110. The current capacity of the battery 110 may be determined as a value obtained by subtracting a capacity decrease according to a degree of current degradation of the battery 110 from an initial capacity of the battery 110. The initial capacity of the battery 110 is a capacity before the battery 110 is used, and may be determined according to the number of cells in the battery 110 and the chemical composition of the battery.

The BMS 150 may estimate an SOC of the battery 110 by using one of the following methods: a current integration method that integrates charge and discharge currents, an electrochemical modeling method that expresses a chemical reaction inside a cell in units of molecules, a mathematical formula technique that expresses a dynamic behavior such as an operating time and a state of charge (SOC) of the battery 110 as a purely mathematical empirical formula, and a voltage modeling method that uses a relationship between an open circuit voltage (OCV) and a state of charge (SOC).

In addition, the BMS 150 may determine a highest SOC of the battery 110 and a lowest SOC of the battery 110. The SOC range of the battery 110 according to the highest SOC of the battery 110 and the lowest SOC of the battery 110 refers to an SOC range in which the battery 110 is mainly charged and discharged.

The BMS 150 may determine an SOC when the charging of the battery 110 starts as the lowest SOC of the battery 110, and may determine an SOC when the charging of the battery 110 ends as the highest SOC of the battery 110. When the battery 110 is charged multiple times, the BMS 150 may determine an average of a plurality of lowest SOC values as the lowest SOC value, and determine an average of a plurality of highest SOC values as the highest SOC value.

The BMS 150 may determine a relational expression representing a relationship between a total energy amount of the battery 110 and an SOH of the battery 110 according to the degradation conditions at each monitoring cycle (S1100).

The total energy amount of the battery 110 refers to the sum of energy charged to the battery 110 (hereinafter, battery charge energy) and energy discharged from the battery 110 (hereinafter, battery discharge energy).

According to an exemplary embodiment, the relational expression representing the relationship between the total energy amount of the battery 110 and the SOH of the battery 110 may be defined as Formula 1. [Formula 1] $\left(Battery SOH\right) = 100 \frac{{1}^{\left(total energy amount of battery\right)}}{a}$

α may be defined as Formula 2. [Formula 2] $α = {α}_{0} T + {α}_{1} \sqrt{C} + {α}_{2} \sqrt{D} + {α}_{3} {SOC}_{u} + {α}_{4} {SOC}_{l}$

α₀, α₁, α₂, α₃, and α₄ are parameters determined according to the chemical properties of the battery 110, which may be determined using a table stored in the memory 153. T denotes a temperature of the battery 110, C denotes a charge rate of the battery 110, D denotes a discharge rate of the battery 110, SOC_{U} denotes a highest SOC of the battery 110, and SOC_{I} denotes a lowest SOC of the battery 110.

The BMS 150 may determine a relational expression representing a relationship between a total energy amount of the battery 110 and an SOH of the battery 110 according to the predetermined formula and the stored table.

Referring to FIGS. 3 to 5, graphs can be seen for batteries 110 having different chemical properties and different degradation conditions according to relational expressions each representing a relationship between a total energy amount of each of the batteries 110 and an SOH of each of the batteries 110.

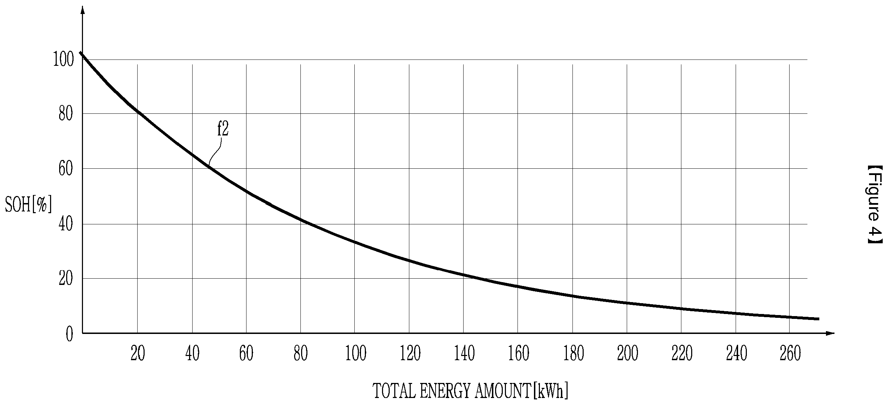

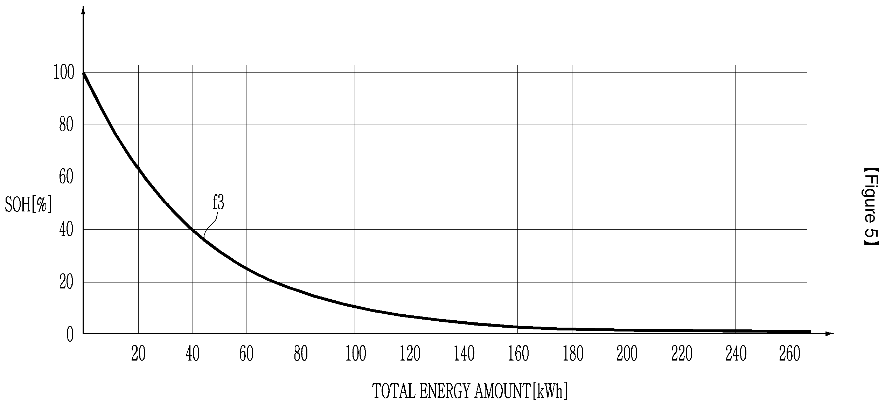

FIG. 4 is a graph f1 according to a first relational expression representing a relationship between the total energy amount of the battery 110 and the SOH of the battery 110 when α is 2, FIG. 5 is a graph f2 according to a second relational expression representing a relationship between the total energy amount of the battery 110 and the SOH of the battery 110 when α is 3, and FIG. 6 is a graph f3 according to a third relational expression representing a relationship between the total energy amount of the battery 110 and the SOH of the battery 110 when α is 10.

The BMS 150 may determine different relational expressions according to the degradation conditions that vary at each monitoring cycle. Referring to FIG. 6, the BMS 150 may estimate an SOH of the battery 110 using the graph f1 according to the first relational expression when α is 2 at a first cycle T1 among the plurality of monitoring cycles, may estimate an SOH of the battery 110 using the graph f2 according to the second relational expression when α is 3 at a second cycle T2, and may estimate an SOH of the battery 110 using the graph f3 according to the third relational expression when α is 10 at a third cycle T3.

The BMS 150 may calculate a SOC change rate of the battery 110 during the monitoring cycle (S1200). Specifically, the BMS 150 may calculate a difference between an SOC of the battery 110 according to the total energy amount of the battery when the monitoring cycle starts and an SOC of the battery 110 according to the total energy amount of the battery when the monitoring cycle ends as the rate of change in SOC of the battery 110.

The BMS 150 may calculate the sum of battery charge energy and battery discharge energy since the operation of the battery 110 first started as the total energy amount of the battery 110. Specifically, the BMS 150 may calculate the charge energy of the battery 110 by multiplying a charge time by the product of the voltage and the current used during charging, and may calculate the discharge energy of the battery 110 by multiplying a discharge time by the product of the voltage and the current used during discharging. However, the method of obtaining the charge energy of the battery 110 and the discharge energy of the battery 110 is not limited thereto, and may be implemented according to various known technologies.

Referring to FIG. 6, the BMS 150 may set the SOH of the battery 110 to 100% (P1) when the total energy amount of the battery 110 is 0 [kWh]. The BMS 150 may calculate the total energy amount of the battery 110 when the first cycle T1 ends. In a case where the total energy amount of the battery 110 is 40 [kWh] when the first cycle T1 ends, the BMS 150 may estimate the SOH of the battery 110 as 77% (P2), and may calculate a difference between the SOH of the battery 110 when the first cycle T1 starts and the SOH of the battery 110 when the first cycle T1 ends, which is 23%, as an SOH change rate ΔSOC1.

When the total energy amount of the battery 110 is 40 [kWh], the BMS 150 may set the SOH of the battery 110 to 77% (P2). In a case where the total energy amount of the battery 110 is 78 [kWh] when the second cycle T2 ends, the BMS 150 may estimate the SOH of the battery 110 as 48% (P3), and may calculate a difference between the SOH of the battery 110 when the second cycle T2 starts and the SOH of the battery 110 when the second cycle T2 ends, which is 29%, as an SOH change rate ΔSOC2. In the same way, the BMS 150 may calculate a difference between the SOH of the battery 110 when the third cycle T3 starts and the SOH of the battery 110 when the third cycle T3 ends, which is 29%, as an SOH change rate ΔSOC3.

The BMS 150 may integrate a plurality of calculated SOH change rates at each cycle (S1300). Specifically, the BMS 150 may integrate a plurality of calculated SOH change rates whenever each cycle ends.

Referring to FIG. 6, the BMS 150 may calculate the sum of the SOH change rate ΔSOC1 of the first cycle and the SOH change rate ΔSOC2 of the second cycle as a final SOH change rate after the second cycle ends, and may update the final SOH change rate to the sum of the SOH change rate ΔSOC1 of the first cycle, the SOH change rate ΔSOC2 of the second cycle, and the SOH change rate ΔSOC3 of the third cycle after the third cycle ends.

The BMS 150 may estimate a current SOH by subtracting the integrated SOH change rate from the initial SOH of the battery (S1400).

For example, if the current time is a time point at which the third cycle ends, the current SOH of the battery 110 may be estimated as 19%, by subtracting 81%, which is the sum of the SOH change rate ΔSOC1 of the first cycle, the SOH change rate ΔSOC2 of the second cycle, and the SOH change rate ΔSOC3 of the third cycle, from 100%, which is the initial SOH of the battery 110.

In addition, when the SOC of the battery 110 decreases to a predetermined value or less, the BMS 150 may communicate with a vehicle control unit to notify the user of the same.

Although the exemplary embodiments of the present disclosure have been described in detail above, the scope of the present disclosure is not limited thereto, and various modifications and improvements made by those having ordinary knowledge in the art to which the present disclosure pertains also fall within the scope of the present disclosure.

## Claims

1. A battery system (100) comprising:
a battery (110); and
a battery management system, BMS (150), **characterised in that** the BMS is configured to obtain degradation conditions related to degradation of the battery (110) at each predetermined monitoring cycle, determine a relational expression representing a relationship between a total energy amount of the battery (110) and a state of health, SOH, of the battery (110) according to the degradation conditions at the each monitoring cycle, and estimate an SOH of the battery (110) according to the relational expression,
wherein the total energy amount of the battery (110) is the sum of charge energy and discharge energy of the battery.

2. The battery system (100) of claim 1, wherein
the degradation conditions include a temperature of the battery (110), a charge rate of the battery (110), a discharge rate of the battery (110), a highest state of charge, SOC, of the battery, and a lowest SOC of the battery.

3. The battery system (100) of claim 2, wherein
the BMS (150) measures the temperature of the battery (110), the charge rate of the battery (110), and the discharge rate of the battery (110), and estimates the highest SOC of the battery (110) and the lowest SOC of the battery (110).

4. The battery system (100) of claim 1, wherein
the BMS (150) calculates an SOH change rate of the battery (110) based on the relational expression at the each monitoring cycle, and estimates a current SOH of the battery by subtracting a value obtained by integrating a plurality of calculated SOH change rates at the each cycle from an initial SOH of the battery (110).

5. The battery system (100) of claim 4, wherein
the BMS (150) estimates a first SOH of the battery (110) according to a total energy amount of the battery (110) when the monitoring cycle starts, estimates a second SOH of the battery (110) according to a total energy amount of the battery (110) when the monitoring cycle ends, and calculates a difference between the first SOH and the second SOH as the SOH change rate.

6. A method for estimating a state of health, SOH, of a battery (110), the method is **characterised by** comprising:
Obtaining (S1000) degradation conditions related to degradation of the battery (110) at each predetermined monitoring cycle;
calculating a total energy amount of the battery by adding charge energy of the battery (110) and discharge energy of the battery; and
determining (S1100) a relational expression representing a relationship between a total energy amount of the battery and a state of health SOH of the battery according to the degradation conditions at the each monitoring cycle, and estimating an SOH of the battery (110) according to the relational expression.

7. The method of claim 6, wherein
the degradation conditions include a temperature of the battery (110), a charge rate of the battery (110), a discharge rate of the battery (110), a highest state of charge, SOC, of the battery (110), and a lowest SOC of the battery (110).

8. The method of claim 7, wherein
the obtaining of the degradation conditions includes:
measuring the temperature of the battery (110), the charge rate of the battery (110), and the discharge rate of the battery; and
estimating the highest SOC of the battery (110) and the lowest SOC of the battery (110).

9. The method of claim 6, wherein
the estimating of the SOH of the battery (110) includes:
calculating an SOH change rate of the battery (110) based on the relational expression at the each monitoring cycle; and
subtracting a value obtained by integrating a plurality of calculated SOH change rates at the each cycle from an initial SOH of the battery (110).

10. The method of claim 9, wherein
the calculating of the SOH change rate of the battery (110) includes:
estimating a first SOH of the battery (110) according to a total energy amount of the battery (110) when the monitoring cycle starts;
estimating a second SOH of the battery (110) according to a total energy amount of the battery (110) when the monitoring cycle ends; and
calculating a difference between the first SOH and the second SOH as the SOH change rate.

## Patentansprüche

1. Batteriesystem (100), umfassend:
eine Batterie (110); und
ein Batteriemanagementsystem, BMS (150), **dadurch gekennzeichnet, dass** das BMS konfiguriert ist, um Abbaubedingungen in Bezug auf den Abbau der Batterie (110) bei jedem vorbestimmten Überwachungszyklus zu erhalten, einen relationalen Ausdruck zu bestimmen, der eine Beziehung zwischen einer Gesamtenergiemenge der Batterie (110) und einem Batteriegesundheitszustand, SOH, (110) gemäß den Abbaubedingungen bei jedem Überwachungszyklus darstellt, und einen SOH der Batterie (110) gemäß dem relationalen Ausdruck zu schätzen,
wobei die Gesamtenergiemenge der Batterie (110) die Summe aus Ladeenergie und Entladeenergie der Batterie ist.

2. Batteriesystem (100) nach Anspruch 1, wobei
die Abbaubedingungen eine Temperatur der Batterie (110), eine Laderate der Batterie (110), eine Entladerate der Batterie (110), einen höchsten Batterieladezustand, SOC, und einen niedrigsten SOC der Batterie einschließen.

3. Batteriesystem (100) nach Anspruch 2, wobei
das BMS (150) die Temperatur der Batterie (110), die Laderate der Batterie (110) und die Entladerate der Batterie (110) misst und den höchsten SOC der Batterie (110) und den niedrigsten SOC der Batterie (110) schätzt.

4. Batteriesystem (100) nach Anspruch 1, wobei
das BMS (150) eine SOH-Änderungsrate der Batterie (110) gemäß dem relationalen Ausdruck bei jedem Überwachungszyklus berechnet und einen aktuellen SOH der Batterie schätzt, indem es einen Wert, der durch Integrieren einer Vielzahl von berechneten SOH-Änderungsraten bei jedem Zyklus erhalten wird, von einem anfänglichen SOH der Batterie (110) subtrahiert.

5. Batteriesystem (100) nach Anspruch 4, wobei
das BMS (150) einen ersten SOH der Batterie (110) gemäß einer Gesamtenergiemenge der Batterie (110) schätzt, wenn der Überwachungszyklus beginnt, einen zweiten SOH der Batterie (110) gemäß einer Gesamtenergiemenge der Batterie (110) schätzt, wenn der Überwachungszyklus endet, und eine Differenz zwischen dem ersten SOH und dem zweiten SOH als die SOH-Änderungsrate berechnet.

6. Verfahren zur Schätzung des Batteriegesundheitszustands, SOH, (110), wobei das Verfahren **dadurch gekennzeichnet ist, dass** es Folgendes umfasst:
Erhalten (S1000) von Abbaubedingungen in Bezug auf den Abbau der Batterie (110) bei jedem vorbestimmten Überwachungszyklus;
Berechnen einer Gesamtenergiemenge der Batterie durch Addieren von Ladeenergie der Batterie (110) und Entladeenergie der Batterie; und
Bestimmen (S1100) eines relationalen Ausdrucks, der eine Beziehung zwischen einer Gesamtenergiemenge der Batterie und einem Batteriegesundheitszustand, SOH, gemäß den Abbaubedingungen bei jedem Überwachungszyklus darstellt, und Schätzen eines SOH der Batterie (110) gemäß dem relationalen Ausdruck.

7. Verfahren nach Anspruch 6, wobei
die Abbaubedingungen eine Temperatur der Batterie (110), eine Laderate der Batterie (110), eine Entladerate der Batterie (110), einen höchsten Batterieladezustand, SOC, (110) und einen niedrigsten SOC der Batterie (110) einschließen.

8. Verfahren nach Anspruch 7, wobei
das Erhalten der Abbaubedingungen Folgendes einschließt:
Messen der Temperatur der Batterie (110), der Laderate der Batterie (110) und der Entladerate der Batterie; und
Schätzen des höchsten SOC der Batterie (110) und des niedrigsten SOC der Batterie (110).

9. Verfahren nach Anspruch 6, wobei
das Schätzen des SOH der Batterie (110) Folgendes einschließt:
Berechnen einer SOH-Änderungsrate der Batterie (110) gemäß dem relationalen Ausdruck bei jedem Überwachungszyklus; und
Subtrahieren eines Werts, der durch Integrieren einer Vielzahl von berechneten SOH-Änderungsraten bei jedem Zyklus erhalten wird, von einem anfänglichen SOH der Batterie (110).

10. Verfahren nach Anspruch 9, wobei
das Berechnen der SOH-Änderungsrate der Batterie (110) Folgendes einschließt:
Schätzen eines ersten SOH der Batterie (110) gemäß einer Gesamtenergiemenge der Batterie (110), wenn der Überwachungszyklus beginnt;
Schätzen eines zweiten SOH der Batterie (110) gemäß einer Gesamtenergiemenge der Batterie (110), wenn der Überwachungszyklus endet; und
Berechnen einer Differenz zwischen dem ersten SOH und dem zweiten SOH als die SOH-Änderungsrate.

## Revendications

1. Système de batterie (100) comprenant :
une batterie (110) ; et
un système de gestion de batterie, BMS (150), **caractérisé en ce que** le BMS est configuré pour obtenir des conditions de dégradation liées à la dégradation de la batterie (110) à chaque cycle de surveillance prédéterminé, déterminer une expression relationnelle représentant une relation entre une quantité d'énergie totale de la batterie (110) et un état de santé, SOH, de la batterie (110) selon les conditions de dégradation à chaque cycle de surveillance, et estimer un SOH de la batterie (110) selon l'expression relationnelle,
dans lequel la quantité d'énergie totale de la batterie (110) est la somme de l'énergie de charge et de l'énergie de décharge de la batterie.

2. Le système de batterie (100) selon la revendication 1, dans lequel
les conditions de dégradation incluent une température de la batterie (110), un taux de charge de la batterie (110), un taux de décharge de la batterie (110), un état de charge, SOC, le plus élevé de la batterie, et un SOC le plus bas de la batterie.

3. Le système de batterie (100) selon la revendication 2, dans lequel
le BMS (150) mesure la température de la batterie (110), le taux de charge de la batterie (110) et le taux de décharge de la batterie (110), et estime le SOC le plus élevé de la batterie (110) et le SOC le plus bas de la batterie (110).

4. Le système de batterie (100) selon la revendication 1, dans lequel
le BMS (150) calcule un taux de variation du SOH de la batterie (110) sur la base de l'expression relationnelle à chaque cycle de surveillance, et estime un SOH actuel de la batterie en soustrayant une valeur obtenue en intégrant une pluralité de taux de variation du SOH calculés à chaque cycle d'un SOH initial de la batterie (110).

5. Le système de batterie (100) selon la revendication 4, dans lequel
le BMS (150) estime un premier SOH de la batterie (110) en fonction d'une quantité d'énergie totale de la batterie (110) lorsque le cycle de surveillance commence, estime un deuxième SOH de la batterie (110) en fonction d'une quantité d'énergie totale de la batterie (110) lorsque le cycle de surveillance se termine, et calcule une différence entre le premier SOH et le deuxième SOH en tant que taux de variation du SOH.

6. Procédé pour estimer un état de santé, SOH, d'une batterie (110), le procédé étant **caractérisé en ce qu'**il comprend :
l'obtention (S1000) de conditions de dégradation liées à la dégradation de la batterie (110) à chaque cycle de surveillance prédéterminé ;
le calcul d'une quantité d'énergie totale de la batterie en additionnant l'énergie de charge de la batterie (110) et l'énergie de décharge de la batterie ; et
la détermination (S1100) d'une expression relationnelle représentant une relation entre une quantité d'énergie totale de la batterie et un état de santé SOH de la batterie selon les conditions de dégradation à chaque cycle de surveillance, et l'estimation d'un SOH de la batterie (110) selon l'expression relationnelle.

7. Le procédé selon la revendication 6, dans lequel
les conditions de dégradation incluent une température de la batterie (110), un taux de charge de la batterie (110), un taux de décharge de la batterie (110), un état de charge, SOC, le plus élevé de la batterie (110), et un SOC le plus bas de la batterie (110).

8. Le procédé selon la revendication 7, dans lequel
l'obtention des conditions de dégradation inclut :
la mesure de la température de la batterie (110), du taux de charge de la batterie (110) et du taux de décharge de la batterie ; et
l'estimation du SOC le plus élevé de la batterie (110) et du SOC le plus bas de la batterie (110).

9. Le procédé selon la revendication 6, dans lequel
l'estimation du SOH de la batterie (110) inclut :
le calcul d'un taux de variation du SOH de la batterie (110) sur la base de l'expression relationnelle à chaque cycle de surveillance ; et
la soustraction d'une valeur obtenue en intégrant une pluralité de taux de variation du SOH calculés à chaque cycle d'un SOH initial de la batterie (110).

10. Le procédé selon la revendication 9, dans lequel
le calcul du taux de variation du SOH de la batterie (110) inclut :
l'estimation d'un premier SOH de la batterie (110) en fonction d'une quantité d'énergie totale de la batterie (110) lorsque le cycle de surveillance commence ;
l'estimation d'un deuxième SOH de la batterie (110) en fonction d'une quantité d'énergie totale de la batterie (110) lorsque le cycle de surveillance se termine ; et
le calcul d'une différence entre le premier SOH et le deuxième SOH en tant que taux de variation du SOH.
